(19) Europäisches Patentamt
European Patent Office
Office européen des brevets

(11) **EP 0 640 904 B1**

(12) **EUROPEAN PATENT SPECIFICATION**

(45) Date of publication and mention
of the grant of the patent:
**11.10.2000 Bulletin 2000/41**

(51) Int. Cl.$^{7}$: **G05F 1/46**, G05F 3/30

(21) Application number: **94112574.2**

(22) Date of filing: **11.08.1994**

(54) **Curvature correction circuit for a voltage reference**

Krümmungskorrekturschaltung für Referenzspannung

Circuit de correction de la courbure pour une référence de tension

(84) Designated Contracting States:
**DE FR GB**

(30) Priority: **30.08.1993 US 112917**

(43) Date of publication of application:
**01.03.1995 Bulletin 1995/09**

(73) Proprietor: **MOTOROLA, INC.**
**Schaumburg, IL 60196 (US)**

(72) Inventors:
• **Pigott, John M**
**Phoenix, Arizona 85044 (US)**
• **Jarrett, Robert B.**
**Tempe, Arizona 85284 (US)**
• **Bynum, Byron G.**
**Gilbert, Arizona 85234 (US)**

(74) Representative:
**Hudson, Peter David et al**
**Motorola,**
**European Intellectual Property,**
**Midpoint,**
**Alencon Link**
**Basingstoke, Hampshire RG21 7PL (GB)**

(56) References cited:
**US-A- 4 325 018**      **US-A- 4 443 753**
**US-A- 4 939 442**      **US-A- 5 053 640**

• **PROCEEDINGS OF THE BIPOLAR CIRCUITS AND TECHNOLOGY MEETING, MINNEAPOLIS, SEPT. 17 - 18, 1990, no. -, 17 September 1990, JOPKE J, pages 214-218, XP000202482 PEASE R A: "THE DESIGN OF BAND-GAP REFERENCE CIRCUITS: TRIALS AND TRIBULATIONS"**
• **IEEE JOURNAL OF SOLID-STATE CIRCUITS, vol. 28, no. 6, 1 June 1993, pages 667-670, XP000378425 GUNAWAN M: "A CURVATURE-CORRECTED LOW-VOLTAGE BANDGAP REFERENCE"**

## Description

Background of the Invention

This invention relates, in general, to voltage references, and more particularly to correction circuits to reduce error of a voltage reference.

Voltage references provide an accurate and stable voltage over a wide temperature. It is well known that a bandgap reference is easily integrated on existing semiconductor processes and provides an accurate reference voltage that is extremely stable over temperature. The bandgap reference provides a low temperature coefficient (TC) reference voltage by adding two voltages with opposite temperature coefficients, thus canceling the temperature dependence. The resultant voltage produced by the bandgap reference is approximately the bandgap voltage of the semiconductor material. In the case of a silicon semiconductor, the bandgap reference voltage produced is approximately 1.205 volts. The temperature dependence term canceled is generally a first order term or linear term.

Smaller second and third order temperature dependent terms affect the bandgap reference output voltage, although the largest term (linear term) of the temperature dependent terms is canceled. These remaining temperature dependent terms produce an output voltage that graphically looks like an inverted parabola. The peak of the inverted parabola is a point of zero temperature dependence (zero slope) and is typically centered at a center of a temperature range in which the bandgap reference is used. For example, assume the bandgap reference is used over a temperature range of -40 degrees centigrade to 100 degrees centigrade. The zero temperature coefficient point or peak of the inverted parabola is centered at approximately 30 degrees centigrade. Temperatures above and below 30 degrees centigrade will produce an output voltage less than the approximately 1.205 volts produced at 30 degrees centigrade.

Maximum deviations in output voltage of the bandgap reference due to temperature dependencies are small. From the example described above an output voltage deviation of approximately 8 millivolts over the temperature range (-40 to 100 degrees centigrade) can be expected. This small voltage error makes further correction of the bandgap reference extremely difficult. The problem resides in generating a small voltage with an appropriate temperature coefficient centered at the center point of the bandgap reference. Most attempts at compensation start with large voltages or currents that must be reduced or translated appropriately to generate the small correction voltage. Error produced during translation is invariably on the order of the small voltage being generated and thus is not manufacturable or accurate enough to reduce the bandgap reference temperature dependence. It would be of great benefit if an error correction circuit could be produced that is simple to manufacture, inherently produces a small error correction voltage over the usable temperature range of the bandgap reference without translation, and is easily centered with the bandgap center point.

One prior art bandgap voltage reference circuit providing a stable output reference voltage over a wide temperature range is described in US Patent no. 4,939,442.

Summary of the Invention

In accordance with the present invention there is provided a voltage reference circuit for providing a reference voltage within a predetermined temperature range as recited in claim 1 of the accompanying claims.

Briefly stated, this invention provides error correction for a voltage reference. The voltage reference provides a reference voltage to which a correction voltage is added to minimize variations in the reference voltage over a predetermined temperature range.

Brief Description of the Drawings

FIG. 1 is a schematic diagram of a correction circuit in accordance with the present invention; and

FIG. 2 is a diagram graphically illustrating correction of a reference voltage corresponding to the schematic in FIG. 1.

Detailed Description of the Drawings

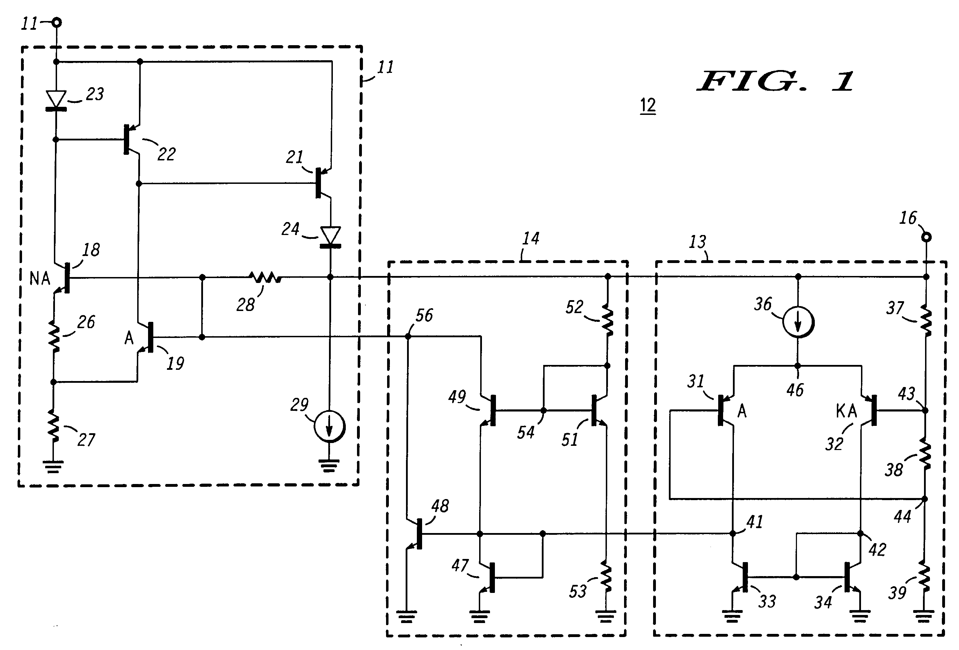

FIG. 1 is a schematic diagram of a voltage reference 11 and a correction circuit 12. Voltage references, in general, provide a reference voltage that is stable over a wide temperature range and varying operating conditions. An example of a common voltage reference used on an integrated circuit is a bandgap voltage reference. The bandgap voltage reference is well known for providing a reference voltage with a low temperature coefficient (TC). The low TC is produced by generating a voltage having a positive temperature coefficient and a voltage with a negative temperature coefficient. The positive and negative TCs negate one another when the voltages are added together producing the low TC reference voltage. Still, not all temperature dependencies are canceled, and the reference voltage varies minutely over temperature. Correcting small voltage, temperature dependent error, can be extremely difficult on a bandgap reference as well as other types of voltage references. Correction circuit 12 reduces temperature dependent error in voltage reference 11 and is easily formed on an integrated circuit in a small area.

In the preferred embodiment, voltage reference 11 is a bandgap voltage reference. A reference voltage is provided at an output 16. Many circuit configurations exist for bandgap voltage references. The circuitry illustrated for voltage reference 11 is for description purposes only. The bandgap voltage reference of voltage reference 11 comprises npn transistors 18, 19, and 21, pnp transistor 22, diodes 23, 24, and resistors 26, 27, and 28.

Diode 23 and pnp transistor 22 form a current mirror for providing an identical current I to npn transistors 18 and 19. Npn transistor 18 has an emitter area (NA) that is a predetermined multiple of an emitter area (A) of npn transistor 19. Equilibrium is reached when I*(resistor 26) + Vbe(transistor 18) = Vbe(transistor 19) . Resistor 26 affects the current magnitude (I) at which equilibrium occurs. NPN transistor 21 in series with diode 24 provides feedback for driving npn transistors 18 and 19 to the stable condition. Current source 29 biases npn transistor 21 and diode 24. Resistor 27 affects the magnitude of the output voltage at output 16.

Voltage reference 11 has a peak voltage at a predetermined temperature somewhere between the end points of the temperature range in which voltage reference 11 is used. The peak voltage will also correspond to a point having a zero temperature coefficient (TC). In the preferred embodiment, the predetermined temperature of the peak voltage is in the center of the temperature range. Voltage error is minimized across the temperature range by centering the zero TC voltage. The temperature at which zero TC point occurs is determined by the emitter area ratio of npn transistors 18 and 19, and the resistance values of resistors 26 and 27. The reference voltage versus temperature produced by the bandgap voltage reference is well known. The reference voltage is a maximum at the zero TC point and is at a minimum at either end point of the temperature range. Resistor 28 in voltage reference 11 is used to add a correction voltage to the reference voltage provided at output 16. Resistor 28 couples between output 16 and a node 56. The bases of transistors 18 and 19 are also coupled to node 56. No current flows through resistor 28 under ideal conditions (npn transistors 18 and 19 have infinite current gain and no correction voltage is needed) thus no voltage is added by resistor 28 to the reference voltage at output 16.

Correction circuit 12 provides no correction at the zero TC point of voltage reference 11 of the example above. Above and below the zero TC point, correction circuit 12 provides a signal of the same sense that reduces temperature dependent error of voltage reference 11. For example, prior to any voltage correction provided by correction circuit 12, voltage reference 11 has a maximum (or peak) voltage within the predetermined temperature range such that the reference voltage provided by voltage reference 11 is less than the maximum voltage at temperatures above and below the temperature corresponding to the maximum voltage. The maximum voltage occurs at a temperature $T_0$ with the predetermined temperature range. Correction circuit 12 provides a signal (of the same sense) above and below the peak voltage, the signal generates a positive voltage to be summed or combined with the reference voltage for reducing variations in the magnitude of the reference voltage over temperature. It should be obvious that if voltage reference 11 had a minimum voltage instead of a maximum voltage that correction circuit 12 would provide a signal (of the same sense) above and below the temperature corresponding to the minimum voltage which generates a negative voltage for reducing variations in the reference voltage.

In the preferred embodiment, correction circuit 12 comprises a circuit 13 and a circuit 14. Circuit 13 provides a correction signal that can be either a current or voltage signal having an approximately linear temperature coefficient. In the preferred embodiment, circuit 13 provides a correction current. The minimum magnitude of the correction current coincides with the maximum voltage (at $T_0$) produced by voltage reference 11. The magnitude is defined as the absolute value of the correction current. The correction current can be described as two distinct current types, a sink current or a source current. Within the operating temperature range of voltage reference 11, the correction current produced by circuit 13 changes from a sink current to a source current. Circuit 14 receives the correction signal generated by circuit 13 and provides an output signal. The output signal of circuit 14 is unidirectional. In other words, circuit 14 generates an "absolute value" function of the correction signal. For example, circuit 14 converts the correction current described above (from circuit 13) to either a sink current (negative current) or a source current (positive current). In the preferred embodiment, the current magnitude of the correction current of circuit 13 is not changed significantly by circuit 14 when converted to the output current. The output current magnitude of circuit 14 increases approximately linearly as temperature is increased or decreased from $T_0$. The output current produced by circuit 14 is coupled through resistor 28 to produce a correction voltage that reduces voltage error of voltage reference 11 over the operating temperature range.

In the preferred embodiment, circuit 13 provides no current or a minimum magnitude current at the maximum voltage ($T_0$) of voltage reference 11. Circuit 13 also produces the correction current with an approximately linear temperature coefficient having a slope suitable for error correction. Circuit 13 comprises transistors 31-34, a current source 36, and resistors 37-39. The reference voltage provided at output 16 provides a stable and accurate voltage for biasing circuit 13.

In the preferred embodiment, transistors 31 and 32 are pnp transistors (conductivity type) and each has a base, a collector, and an emitter corresponding respectively to a control electrode, a first electrode, and a second electrode. Transistors 31 and 32 form an differential input pair. Transistor 32 has an emitter area (KA - corresponding to a conductive area) some multiple (K) of an emitter area (A - corresponding to a conductive area) of transistor 31. Transistor 31 has the base coupled to a node 44, a collector coupled to a node 41, and an emitter coupled to a node 46. Node 41 corresponds to an output of circuit 13 for providing the correction current. Transistor 32 has the base coupled to a node 43, the collector coupled to a node 42, and the emitter coupled to node 46. Current source 36 biases transistors 31 and 32. Current source 36 has a terminal coupled to output 16 and a terminal coupled to node 46.

A current mirror is formed by transistors 33 and 34. In the preferred embodiment, transistors 33 and 34 are npn transistors (conductivity type) having equal emitter areas (conductive areas) and each has a base, a collector, and an emitter corresponding respectively to a control electrode, a first electrode, and a second electrode. Transistor 34 has the base and collector coupled to node 42, and the emitter coupled to ground. Transistor 33 has the base coupled to node 42, the collector coupled node 41, and the emitter coupled to ground.

A differential input voltage (the voltage drop across resistor 38) is applied across the bases of transistors 31 and 32. In the preferred embodiment the differential input voltage is formed by a resistor divider comprising resistors 37-39. Resistor 37 has a terminal coupled to output 16 and a terminal coupled to node 43. Resistor 38 has a terminal coupled to node 43 and a terminal coupled to node 44, and resistor 39 has a terminal coupled to node 44 and a terminal coupled to ground.

In the preferred embodiment, operation of circuit 13 provides zero correction current at the maximum voltage ($T_0$) of voltage reference 11. This occurs when the current through transistors 31 and 33 are equal to the current through transistors 32 and 34, thus no output current is provided by circuit 13. For example, voltage reference 11 provides a reference voltage $V_{ref}$ at output 16. The resistor divider is designed such that the voltage drop ($V_d$) across resistor 38 compensates for the difference in emitter area of transistors 31 and 32 at $T_0$. The required voltage is described by equation 1:

$$V_d(T=T_0) = (kT_{0/q}) * \ln(K) \tag{1}$$

where q = electron charge, k = Boltzmann's constant, and K = emitter area(transistor 32) / emitter area (transistor 31) . The voltage drop across resistor 38 is described by equation 2. R37, R38, and R39 corresponds respectively to the resistor values of resistors 37, 38, and 39.

$$V_d = V_{ref} * (R38 / (R37 + R38 + R39)) \tag{2}$$

The correction current from circuit 13 changes approximately proportionally as the temperature moves in either direction from $T_0$. Bipolar transistors have predictable characteristics which allows accurate placement of the temperature $T_0$. Furthermore, the bandgap voltage reference provides an accurate voltage from which the resistor divider (resistors 37-39) can generate the voltage $V_d$, and the resistor divider is not a function of absolute resistor value, but a ratio of resistor sizes which is easily manufactured on an integrated circuit. Equivalent results could be achieved by ratioing current mirror emitter areas instead of the differential input stage emitter areas.

Circuit 14 changes the correction current of circuit 13 to a unidirectional current. Circuit 14 comprises transistors 47, 48, 49, and 51, and resistors 52 and 53. Like circuit 13, circuit 14 uses the reference voltage provided by voltage reference 11 at output 16. In the preferred embodiment, transistors 47, 48, 49, and 51 are npn transistors (conductivity type) and each has a base, a collector, and an emitter corresponding respectively to a control electrode, a first electrode, and a second electrode. Circuit 14 has an input coupled to node 41 of circuit 13 and an output coupled to node 56.

As mentioned previously, the correction current provided by circuit 13 will change from a source to a sink current over the operating temperature range. In the preferred embodiment, the output current of circuit 14 is a sink current over the operating predetermined temperature range of voltage reference 11. The sink current is coupled to resistor 28 for generating a correction voltage therewith. The voltage generated across resistor 28 is summed or combined with the reference voltage provided by voltage reference 11. Transistor 21 will source the additional current through resistor 28 to circuit 14 to maintain the bandgap reference in the stable condition.

Resistors 52 and 53, and transistor 51 in a diode configuration generate a bias voltage for circuit 14. Resistor 52 has a terminal coupled to output 16 and a terminal coupled to a node 54. Transistor 51 has the base and the collector coupled to node 54. Resistor 53 has a terminal coupled to the emitter of transistor 51 and a terminal coupled to ground. The voltage at node 54 is described by equation 3. R52 and R53 corresponds respectively to the resistor values of resistors 52 and 53. T51 corresponds to transistor 51.

$$V_{node54} = V_{ref} * (R53 / (R52 + R53)) + Vbe(T51) \tag{3}$$

Transistor 47 is in a diode configuration. Transistor 47 has the base and the collector coupled to node 41, and the emitter coupled to ground. Transistor 49 has the base coupled to node 54, the collector coupled to node 56, and the emitter coupled to node 41. Transistor 48 has the base coupled to node 41, the collector coupled to node 56, and the emitter coupled to ground. In the preferred embodiment, the voltage at node 54 is chosen to be slightly more than a Vbe of a transistor. For example, the voltage at node 54 is at a Vbe + 100 millivolts. Biasing circuit 14 as such allows it to operate in two separate modes.

The first mode of operation occurs when circuit 13 sources a current to the bases of transistors 47 and 48. The source current is converted to a sink current by circuit 14. Node 41 is at a voltage of approximately a Vbe under this condition. From the example above, node 54 is at a Vbe + 100 millivolts. This leaves a voltage across the base-emitter junction of transistor 49 of approximately 100 millivolts, thus transistor 49 is off. Transistor 48 mirrors the correction current sourced to transistor 47 by circuit 13. The magnitude of the output current generated by transistor 48 can be adjusted by changing the emitter area ratio of transistors 48 and 47. The output current from circuit 14 produces a correction voltage across resistor 28 increasing the reference voltage at output 16.

The second mode of operation occurs when circuit 13 sinks a current to circuit 14. Under this condition node 41 falls to a voltage significantly less than a Vbe. Transistors 47 and 48 are off. Transistor 49 is then enabled and acts similarly to a cascode device for transistor 33 of circuit 13. Transistor 49 generates the output current for circuit 14 which is approximately the correction current provided by circuit 13. The output current from transistor 49 of circuit 14 produces a correction voltage across resistor 28 increasing the reference voltage at output 16. In either the first or second mode of operation, the preferred embodiment of circuit 14 produces the output current having a magnitude similar to the magnitude of the correction current provided by circuit 13.

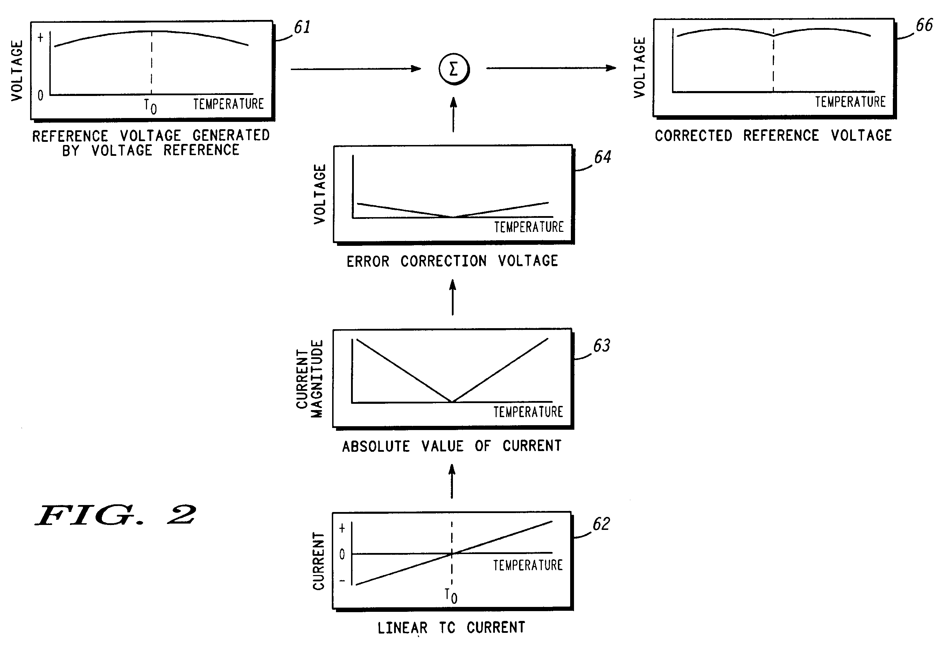

FIG. 2 is a diagram graphically illustrating error correction of voltage reference 11 (FIG. 1) as provided by correction circuit 12 (FIG. 1). Box 61 illustrates the reference voltage supplied by voltage reference 11. The reference voltage peaks at $T_0$ with the reference voltage falling as temperature increases or decreases from $T_0$. Box 62 illustrates the correction current generated by circuit 13 (FIG. 1) versus temperature. The correction current has an approximately linear temperature coefficient and is centered such that circuit 13 outputs zero current at $T_0$. Circuit 13 provides either a source or sink current as temperature varies from $T_0$. Box 63 illustrates the output current provided by circuit 14 (FIG. 1). The correction current from circuit 13 is converted to a unidirectional output current by circuit 14. Box 64 illustrates a small error correction voltage generated from the output current of circuit 14. The specific method for generating this voltage will be determined by the circuit topology of voltage reference 11. The error correction voltage of box 64 is summed or combined with the reference voltage to yield box 66. Voltage reference 11 in conjunction with correction circuit 12 produces the reference voltage having small deviations over the predetermined temperature range.

Referring back to FIG. 1, correction circuit 12 is easily tested through a single output pad. In the preferred embodiment, either the amount of voltage correction provided by correction circuit 12 is monitored or the output current of circuit 14 is monitored, at a predetermined temperature to determine functionality. Resistor 38 of circuit 13 can be made trimmable to adjust correction circuit 12 precisely. It should be noted that equivalents of circuits 13 and 14 can also be designed with CMOS (complementary metallic oxide semiconductors) or BiCMOS (bipolar and CMOS).

By now it should be appreciated that a correction circuit 12 for a voltage reference 11 has been provided. Correction circuit 12 not only reduces temperature error but is added as a peripheral circuit to voltage reference 11. Correction circuit 12 requires only resistor or transistor matching of components for accuracy which is easily achieved on integrated circuit processes. Voltage correction is "zero based" such that no correction is provided by correction circuit 12 at a predetermined temperature. Testing requires only a single test pad to monitor correction circuit 12 output.

**Claims**

1. A voltage reference circuit (12) for providing a reference voltage within a predetermined temperature range, the voltage reference circuit (12) comprising a reference circuit (11) for providing an output voltage, said output voltage being a maximum at a predetermined temperature within the predetermined temperature range, the voltage reference circuit (12) characterised by;

   a first circuit (13) for providing a correction current, said correction current having an approximately linear temperature coefficient over the predetermined temperature range and wherein the magnitude of said correction current being a minimum at said predetermined temperature, wherein said first circuit comprises:

    a differential transistor pair (31, 32) responsive to a differential input voltage; and
    a current mirror circuit (33, 34) coupled to said differential transistor pair for providing said correction current;

   a second circuit (14) responsive to said correction current for providing an output current, said output current being uni-directional over said predetermined temperature range, wherein said second circuit comprises:

a first transistor (49) having a control electrode for receiving a bias voltage, a first electrode coupled to an output of said second circuit for providing said output current, and a second electrode coupled to an input of said second circuit for receiving said correction current;

a second transistor (47) having a control electrode and a first electrode coupled to said input of said second circuit, and a second electrode coupled to a terminal of a first power supply; and

a third transistor (48) having a control electrode coupled to said input of said second circuit, a first electrode coupled to said output of said second circuit, and a second electrode coupled to said terminal of said first power supply; and

means (28) responsive to said second circuit for producing a correction voltage over said predetermined temperature range, said correction voltage being added to said output voltage of said reference circuit (11) to generate the reference voltage.

2. A voltage reference circuit as recited in claim 1 wherein said correction current provided by said first circuit (13) is approximately zero at the predetermined temperature.

3. A voltage reference circuit as recited in claim 1 or 2 wherein the reference circuit (11) is a bandgap voltage reference circuit.

4. A voltage reference circuit (12) as recited in claim 3 wherein said first (13) and second (14) circuits are biased by said bandgap voltage reference circuit.

5. A voltage reference circuit as recited in claim 1, 2, 3, or 4 wherein said first circuit (13) has an output for providing said correction current, said differential transistor pair comprising:

a fourth transistor (31) of a first conductivity type including a control electrode, a first electrode coupled to said output of said first circuit (13), and a second electrode;

a fifth transistor (32) of said first conductivity type including a control electrode, a first electrode, and a second electrode coupled to said second electrode of said fourth transistor (31), said differential input voltage being applied across said control electrodes of said fourth (31) and fifth (32) transistors;

wherein said current mirror circuit comprises:

a sixth transistor (34) of a second conductivity type including a control electrode and a first electrode coupled to said first electrode of said fifth transistor (32), and a second electrode coupled to said terminal of said first power supply; and

a seventh transistor (33) of said second conductivity type including a control electrode coupled to said first electrode of said sixth transistor (34), a first electrode coupled to said output of said first circuit (13), and a second electrode coupled to said terminal of said first power supply;

and wherein said first circuit further comprises:

a current source (36) for biasing said fourth (31) and fifth (32) transistors, said current source (36) having a terminal coupled to a terminal of a second power supply, and a second terminal coupled to said second electrode of said fourth transistor (31).

6. A circuit as recited in claim 5 further including:

a first resistor (37) coupled between said terminal of said second power supply and said control electrode of said fifth transistor (32);

a second resistor (38) coupled between said control electrode of said fourth transistor (31) and said control electrode of said fifth transistor (32);

a third resistor (39) coupled between said control electrode of said fourth transistor (31) and said terminal of said first power supply, said first (37), second (38), and third (39) resistors forming a resistor divider for generating said differential input voltage;

an eighth transistor (51) of said second conductivity type including a control electrode and a first electrode coupled to said control electrode of said first transistor (49), and a second electrode;

a fourth resistor (52) coupled between said first terminal of said second power supply and said control electrode of said first transistor (49); and

a fifth resistor (53) coupled between said second electrode of said eighth transistor (51) and said terminal of said first power supply, said eighth transistor (51), fourth resistor (52), and fifth resistor (53) generating said bias voltage.

**7.** A circuit as recited in claim 6 wherein said fifth transistor (32) has a conductive area some multiple of a conductive area of said fourth transistor (31).

**8.** A circuit as recited in claim 6 or 7 wherein said second resistor (38) is made trimmable to adjust said output current of said second circuit (14) with respect to temperature.

**Patentansprüche**

**1.** Spannungsreferenzschaltung (12) zum Liefern einer Referenzspannung innerhalb eines vorbestimmten Temperaturbereichs, wobei die Spannungsreferenzschaltung (12) eine Referenzschaltung (11) zum Liefern einer Ausgangsspannung umfasst, wobei die Ausgangsspannung bei einer vorbestimmten Temperatur innerhalb des vorbestimmten Temperaturbereichs maximal ist, gekennzeichnet durch;

eine erste Schaltung (13) zum Liefern eines Korrekturstroms, wobei der Korrekturstrom einen näherungsweise linearen Temperaturkoeffizienten über dem vorbestimmten Temperaturbereich aufweist und wobei die Größe des Korrekturstroms bei der vorbestimmten Temperatur minimal ist, wobei die erste Schaltung aufweist:

ein differentielles Transistorpaar (33, 32), welches auf eine differentielle Eingangsspannung anspricht; und

eine Stromspiegelschaltung (33, 34), welche mit dem differentiellen Transistorpaar verbunden ist, zum Liefern des Korrekturstroms;

eine zweite Schaltung (14), welche auf den Korrekturstrom anspricht, zum Liefern eines Ausgangsstroms, wobei der Ausgangsstrom über dem vorbestimmten Temperaturbereich unidirektional ist, wobei die zweite Schaltung aufweist:

einen ersten Transistor (49) mit einer Steuerelektrode zum Empfangen einer Vorspannung, einer ersten Elektrode, welche mit einem Ausgang der zweiten Schaltung verbunden ist, zum Liefern des Ausgangsstroms und eine zweit Elektrode, welche mit einem Eingang der zweiten Schaltung verbunden ist, zum Aufnehmen des Korrekturstroms;

einen zweiten Transistor (47) mit einer Steuerelektrode und einer ersten Elektrode, welche mit dem Eingang der zweiten Schaltung verbunden ist, und einer zweiten Elektrode, welche mit einem Anschluss einer ersten Spannungsversorgung verbunden ist; und

einen dritten Transistor (48) mit einer Steuerelektrode, welche mit dem Eingang der zweiten Schaltung verbunden ist, einer ersten Elektrode, welche mit dem Ausgang der zweiten Schaltung verbunden ist, und einer zweiten Elektrode, welche mit dem Anschluss der ersten Spannungsversorgung verbunden ist;

und eine Einrichtung (28), welche auf die zweite Schaltung anspricht, zum Erzeugen einer Korrekturspannung über dem vorbestimmten Temperaturbereich, wobei die Korrekturspannung zur Ausgangsspannung der Referenzschaltung (11) zum Erzeugen der Referenzspannung hinzufügbar ist.

**2.** Spannungsreferenzschaltung nach Anspruch 1, dadurch gekennzeichnet, dass der von der ersten Schaltung (13) gelieferte Korrekturstrom bei der vorbestimmten Temperatur näherungsweise Null ist.

**3.** Spannungsreferenzschaltung nach Anspruch 1 oder 2, dadurch gekennzeichnet, dass die Referenzschaltung (11) eine Bandlückenspannungsreferenzschaltung ist.

**4.** Spannungsreferenzschaltung (12) nach Anspruch 3, dadurch gekennzeichnet, dass die erste (13) und die zweite (14) Schaltung durch die Bandlückenspannungsreferenzschaltung vorspannbar sind.

5. Spannungsreferenzschaltung nach Anspruch 1, 2, 3 oder 4, dadurch gekennzeichnet, dass die erste Schaltung (13) einen Ausgang zum Liefern des Korrekturstroms aufweist, wobei das differentielle Transistorpaar umfasst:

einen vierten Transistor (31) eines ersten Leitungstyps mit einer Steuerelektrode, einer ersten Elektrode, welche mit dem Ausgang der ersten Schaltung (13) verbunden ist, und einer zweiten Elektrode;

einen fünften Transistor (32) des ersten Leitungstyps mit einer Steuerelektrode, einer ersten Elektrode und einer zweiten Elektrode, welche mit der zweiten Elektrode des vierten Transistors (31) verbunden ist, wobei die differentielle Eingangsspannung über die Steuerelektroden des vierten (31) und fünften (32) Transistors anlegbar ist;

wobei die Stromspiegelschaltung aufweist:

einen sechsten Transistor (24) des zweiten Leitungstyps mit einer Steuerelektrode und einer ersten Elektrode, welche mit der ersten Elektrode des fünften Transistors (32) verbunden ist, und einer zweiten Elektrode, welche mit dem Anschluss der ersten Spannungsversorgung verbunden ist; und
eine siebten Transistor (33) des zweiten Leitungstyps einschließlich einer Steuerelektrode, welche mit der ersten Elektrode des sechsten Transistors (34) verbunden ist, einer ersten Elektrode, welche mit dem Ausgang der ersten Schaltung (13) verbunden ist, und einer zweiten Elektrode, welche mit dem Anschluss der ersten Spannungsversorgung verbunden ist;

und wobei die erste Schaltung weiterhin aufweist:

eine Stromquelle (36) zum Vorspannen des vierten (31) und fünften (32) Transistors, wobei die Stromquelle (36) einen Anschluss mit einem Anschluss einer zweiten Spannungsversorgung verbunden hat, und einen zweiten Anschluss mit der zweiten Elektrode des vierten Transistors (31) verbunden hat.

6. Schaltung nach Anspruch 5, gekennzeichnet durch:

einen ersten Widerstand (37), welcher zwischen dem Anschluss der zweiten Spannungsversorgung und der Steuerelektrode des fünften Transistors (32) geschaltet ist;

einen zweiten Widerstand (38), welcher zwischen die Steuerelektrode des vierten Transistors (31) und, die Steuerelektrode des fünften Transistors (32) geschaltet ist;

einen dritten Transistor (3), welcher zwischen die Steuerelektrode des vierten Transistors (31) und den Anschluss der ersten Spannungsversorgung geschaltet ist, wobei der erste (37), zweite (38) und dritte (39) Widerstand ein Widerstandsteiler zum Erzeugen der differentiellen Eingangsspannung bilden;

einen achten Transistor (51) des zweiten Leitungstyps einschließlich einer Steuerelektrode und einer ersten Elektrode, welche mit der Steuerelektrode des ersten Transistors (49) verbunden ist, sowie einer zweiten Elektrode;

einen vierten Widerstand (52), welcher zwischen den ersten Anschluss der zweiten Spannungsversorgung und die Steuerelektrode des ersten Transistors (49) geschaltet ist; und

einen fünften Widerstand (53), welcher zwischen die zweite Elektrode des achten Transistors (51) und den Anschluss der ersten Spannungsversorgung geschaltet ist, wobei der achte Transistor (51), der vierte Widerstand (52) und der fünfte Widerstand (53) die Vorspannung erzeugen.

7. Schaltung nach Anspruch 6, dadurch gekennzeichnet, dass der fünfte Transistor (32) einen leitenden Bereich aufweist, welcher ein Vielfaches eines leitenden Bereichs des vierten Transistors (31) ist.

8. Schaltung nach Anspruch 6 oder 7, dadurch gekennzeichnet, dass der zweite Widerstand (38) zum Einstellen des Ausgangsstroms der zweiten Schaltung (14) bezüglich der Temperatur trimmbar gestaltet ist.

**Revendications**

1. Circuit de référence de tension (12) servant à produire une tension de référence à l'intérieur d'un intervalle de température prédéterminé, le circuit de référence de tension (12) comprenant un circuit de référence (11) servant à produire une tension de sortie, ladite tension de sortie étant maximale à une température prédéterminée comprise à l'intérieur de l'intervalle de température prédéterminé, le circuit de référence de tension (12) étant caractérisé par :

   un premier circuit (13) servant à produire un courant de correction, ledit courant de correction ayant un coefficient de température approximativement linéaire sur l'intervalle de température prédéterminé, et l'intensité dudit courant de correction étant minimale à ladite température prédéterminée, où ledit premier circuit comprend :

   une paire de transistors différentielle (31, 32) répondant à une tension d'entrée différentielle ; et
   un circuit miroir de courant (33, 34) couplé à ladite paire de transistors différentielle afin de produire ledit courant de correction ;

   un deuxième circuit (14) qui répond audit courant de correction en produisant un courant de sortie, ledit courant de sortie étant unidirectionnel sur ledit intervalle de température prédéterminé, où ledit deuxième circuit comprend :

   un premier transistor (49) possédant une électrode de commande destinée à recevoir une tension de polarisation, une première électrode couplée à une sortie dudit deuxième circuit afin de produire ledit courant de sortie, et une deuxième électrode couplée à une entrée dudit deuxième circuit afin de recevoir ledit courant de connexion ;
   un deuxième transistor (47) ayant une électrode de commande et une première électrode couplées à ladite entrée dudit deuxième circuit, et une deuxième électrode couplée à une borne d'une première alimentation électrique ; et
   un troisième transistor (48) ayant une électrode de commande couplée à ladite entrée dudit deuxième circuit, une première électrode couplée à ladite sortie dudit deuxième circuit, et une deuxième électrode couplée à ladite borne de ladite première alimentation électrique ; et
   un moyen (28) qui répond audit deuxième circuit en produisant une tension de correction sur ledit intervalle de température prédéterminé, ladite tension de correction étant ajoutée à ladite tension de sortie dudit circuit de référence (11) afin de produire la tension de référence.

2. Circuit de référence de tension selon la revendication 1, où ledit courant de correction produit par ledit premier circuit (13) est approximativement nul à la température prédéterminée.

3. Circuit de référence de tension selon la revendication 1 ou 2, où le circuit de référence (11) est un circuit de référence de tension à barrière de potentiel.

4. Circuit de référence de tension (12) selon la revendication 3, où lesdits premier circuit (13) et deuxième circuit (14) sont polarisés par ledit circuit de référence de tension à barrière de potentiel.

5. Circuit de référence de tension selon la revendication 1, 2, 3 ou 4, où ledit premier circuit (13) possède une sortie servant à produire ledit courant de correction, ladite paire de transistors différentielle comprenant :

   un quatrième transistor (31) d'un premier type de conductivité comportant une électrode de commande, une première électrode couplée à ladite sortie dudit premier circuit (13), et une deuxième électrode ;
   un cinquième transistor (32) dudit premier type de conductivité comportant une électrode de commande, une première électrode, et une deuxième électrode couplée à ladite deuxième électrode dudit quatrième transistor (31), ladite tension d'entrée différentielle étant appliquée entre lesdites électrodes de commande desdits quatrième transistor (31) et cinquième transistor (32) ;

   où ledit circuit miroir de courant comprend :

   un sixième transistor (34) d'un deuxième type de conductivité comportant une électrode de commande et une première électrode couplées à ladite première électrode dudit cinquième transistor (32), et une deuxième électrode couplée à ladite borne de ladite première alimentation électrique ; et

un septième transistor (33) dudit deuxième type de conductivité comportant une électrode de commande couplée à ladite première électrode dudit sixième transistor (34), une première électrode couplée à ladite sortie dudit premier circuit (13), et une deuxième électrode couplée à ladite borne de ladite première alimentation électrique ;

et où ledit premier circuit comprend en outre :

une source de courant (36) servant à polariser lesdits quatrième transistor (31) et cinquième transistor (32), ladite source de courant (36) ayant une borne couplée à une borne d'une deuxième alimentation électrique, et une deuxième borne couplée à ladite deuxième électrode dudit quatrième transistor (31).

6. Circuit selon la revendication 5, comportant en outre :

une première résistance (37) couplée entre ladite borne de ladite deuxième alimentation électrique et ladite électrode de commande dudit cinquième transistor (32) ;
une deuxième résistance (38) couplée entre ladite électrode de commande dudit quatrième transistor (31) et ladite électrode de commande dudit cinquième transistor (32) ;
une troisième résistance (39) couplée entre ladite électrode de commande dudit quatrième transistor (31) et ladite borne de ladite première alimentation électrique, lesdites première résistance (37), deuxième résistance (38) et troisième résistance (39) formant un diviseur à résistances servant à produire ladite tension d'entrée différentielle ;
un huitième transistor (51) dudit deuxième type de conductivité comportant une électrode de commande et une première électrode couplées à ladite électrode de commande dudit premier transistor (49), et une deuxième électrode ;
une quatrième résistance (52) couplée entre ladite première borne de ladite deuxième alimentation électrique et ladite électrode de commande dudit premier transistor (49) ; et
une cinquième résistance (53) couplée entre ladite deuxième électrode dudit huitième transistor (51) et ladite borne de ladite première alimentation électrique, lesdits huitième transistor (51), quatrième résistance (52) et cinquième résistance (53) produisant ladite tension de polarisation.

7. Circuit selon la revendication 6, où ledit cinquième transistor (32) possède une aire conductrice qui est un certain multiple de l'aire conductrice dudit quatrième transistor (31).

8. Circuit selon la revendication 6 ou 7, où ladite deuxième résistance (38) est rendue ajustable afin que l'on puisse ajuster ledit courant de sortie dudit deuxième circuit (14) relativement à la température.

FIG. 1

EP 0 640 904 B1

FIG. 2

REFERENCE VOLTAGE GENERATED
BY VOLTAGE REFERENCE

ERROR CORRECTION VOLTAGE

CORRECTED REFERENCE VOLTAGE

ABSOLUTE VALUE OF CURRENT

LINEAR TC CURRENT

EP 0 640 904 B1